(19) Europäisches Patentamt
European Patent Office
Office européen des brevets

(11) **EP 2 320 564 A2**

(12) **EUROPÄISCHE PATENTANMELDUNG**

(43) Veröffentlichungstag:
**11.05.2011 Patentblatt 2011/19**

(51) Int Cl.:
***H03H 11/20*** *(2006.01)*

(21) Anmeldenummer: **10189363.4**

(22) Anmeldetag: **29.10.2010**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(30) Priorität: **30.10.2009 EP 09174615**

(71) Anmelder: **Technische Universität Dresden
01069 Dresden (DE)**

(72) Erfinder: **Mayer, Uwe
01159 Dresden (DE)**

(74) Vertreter: **Lippert, Stachow & Partner
Patentanwälte
Krenkelstrasse 3
01309 Dresden (DE)**

(54) **Schaltung und Verfahren zur Einstellung einer Phase eines Signals**

(57) Der Erfindung, welche eine Anordnung und ein Verfahren zur Einstellung einer Phase eines Signals betrifft, liegt die Aufgabe zugrunde, eine Anordnung und ein Verfahren anzugeben, womit die Nachteile aus dem Stand der Technik überwunden werden und eine Einstellung der Phase in einem Bereich von 360° bereitgestellt wird. Die Aufgabe wird anordnungsseitig dadurch gelöst, dass ein Zirkulator (4) eine in einem Phasenstellbereich zwischen $-g_{m\,2.max} \leq g_{m\,2} \leq g_{m\,2.max}$ einstellbare Transkonduktanz $g_{m\,2}$ aufweist, und dass zwischen dem Eingang ($U_e$) und dem Zirkulator (4) oder zwischen dem Zirkulator (4) und dem Ausgang ($U_a$) ein Vorzeichenumschalter (5) angeordnet ist. Die Aufgabe wird verfahrensseitig dadurch gelöst, dass das Signal in einem ersten Phasenstellbereich zwischen 0° und 180° einstellbar ist und eine Einstellung des Signals in einem zweiten Phasenstellbereich zwischen 180° und 360° mittels eines eingangs- oder ausgangsseitigen Mittels zur Phasenumkehr realisiert wird.

FIG 3

EP 2 320 564 A2

**Beschreibung**

Die Erfindung betrifft eine Anordnung zur Einstellung einer Phase eines Signals, bei welcher zwischen einem Eingang $U_e$ und einem Ausgang $U_a$ ein Zirkulator angeordnet ist.

Die Erfindung betrifft auch ein Verfahren zur Einstellung einer Phase eines Signals, bei welchem die Phase mittels eines Zirkulators einstellbar ist.

Signale werden beispielsweise mittels einer Darstellung ihres Real- und Imaginärteils oder ihrer Amplitude und Phase beschrieben. In einigen Bereichen der Signalverarbeitung ist es notwendig, die Phase oder Phasenlage sowie die Amplitude eines Signals vor dessen Verarbeitung einzustellen. Der Schwerpunkt dieser Beschreibung liegt bei der Einstellung der Phase.

Im Stand der Technik existiert eine Reihe von verschiedenen Lösungsansätzen für diese Problemstellung. Diese lassen sich in zwei grundsätzliche, gleichwertige Kategorien unterteilen:

• Einstellung von Betrag und Phase mittels zweier geeigneter Schaltungen

• Aufteilung des Signals in meist orthogonale Vektoren der komplexen Ebene, welche unabhängig voneinander verstärkt und anschließend wieder addiert werden (sogenannte Vektor-Modulatoren).

Da die vorliegende Erfindung in die erste Gruppe fällt, sollen nachfolgend gegenwärtige Lösungen für Schaltungen, welche die Phase eines Signals steuern können, näher betrachtet werden.

Es existieren Lösungen, wie beispielsweise F. Ellinger, H. Jäckel, and W. Bächtold, "Varactor-loaded transmission-line phase shifter at C-band using lumped elements", IEEE Trans. Microwave Theory & Tech., vol. 51, pp. 1135-1140, April 2003, C. Lu, A.H. Pham, and D. Livezey, "On the feasibility of CMOS multiband phase shifters for multiple-antenna transmitters", IEEE Microwave and Wireless components letters, vol. 16, pp. 255-257, May 2006 oder J. Wagner, U. Mayer und F. Ellinger, "Passive transmission line phase shifter at C-band in CMOS using lumped elements", IEEE International Conference on Microwaves, Radar and Wireless Communication, pp. 1-4, May 2008, welche schaltbare oder variable Übertragungsleitungen bzw. Übertragungsleitungen basierend auf verteilten Elementen verwenden.

Nachteilig an diesen Lösungen sind der meist große Flächenbedarf in integrierten Schaltungen und die vergleichsweise hohen Dämpfungen des Signals. Außerdem werden meist große Steuerspannungen für die steuerbaren Kondensatoren benötigt. Überdies besteht meist eine hohe Verkopplung der Phase mit der Dämpfung.

In anderen aus dem Stand der Technik bekannten Lösungen werden sogenannte Reflexionsphasenschieber, wie in S. Lucyszyn, I. D. Robertson, "Decade bandwidth MMIC analogue phase shifter", IEE Colloquium on Multi-Octave Microwave Circuits, pp. 2/1-2/6, Nov. 1991 oder H. Hayashi; M. Muraguchi, "An MMIC active phase shifter using a variable resonant circuit", IEEE MTT-S International Microwave Symposium Digest, vol. 3, pp. 1573-1576, June 1998 beschrieben, verwendet.

Auch diese Lösungen leiden unter einem meist hohen Flächenbedarf und vergleichsweise hohen Dämpfungen. Auch hier werden meist große Steuerspannungen für die steuerbaren Kondensatoren benötigt.

In Y. Zheng, and C. E. Saavedra, "An ultra-compact CMOS variable phase shifter for 2.4-GHz ISM applications", IEEE Trans. Microwave Theory & Tech., vol. 56, no. 6, pp. 1349-1354, June 2008 wurde ein Lösungsansatz basierend auf sogenannten Zirkulatoren vorgestellt.

Auch diese Lösung weist den Nachteil auf, dass meist große Steuerspannungen für die steuerbaren Kondensatoren benötigt werden.

In U. Mayer, F. Ellinger and R. Eickhoff, "Compact Circulator Based Phase Shifter at C-Band in BiCMOS", IEEE Radio Frequency Integrated Circuits Symposium, June 2009 wird ein weiterer Ansatz mittels eines Verfahrens zur Steuerung einer Phasenkontrollschaltung, welcher auch als Phasenschieber oder Zirkulator bezeichnet wird, vorgeschlagen.

Diese Lösung lässt aber nur einen geringen Steuerbereich von theoretisch max. 90° zu und ist somit, unter Vernachlässigung einer aufwändigen trivialen Aneinanderreihung mehrerer derartiger Schaltungen, nicht ausreichend für eine Einstellung der Phase eines Signals.

Die Aufgabe der Erfindung besteht somit darin, eine Anordnung zur Einstellung der Phase eines Signals sowie ein zugehöriges Verfahren anzugeben, womit die Nachteile aus dem Stand der Technik überwunden werden und eine Einstellung der Phase in einem Bereich von 360° bereitgestellt wird.

Gemäß der Erfindung wird die Aufgabe anordnungsseitig dadurch gelöst, dass der Zirkulator eine in einem Phasenstellbereich zwischen $-g_{m2.max} \leq g_{m2} \leq g_{m2.max}$ einstellbare Transkonduktanz $g_{m2}$ aufweist, und dass zwischen dem Eingang $U_e$ und dem Zirkulator oder zwischen dem Zirkulator und dem Ausgang $U_a$ ein Vorzeichenumschalter angeordnet ist.

Aus dem Stand der Technik ist die Steuerung der Transkonduktanz $g_{m2}$ im Phasenstellbereich von $0 \leq g_{m2} \leq g_{m2.max}$ mittels einer Phasenschieberanordnung bekannt, was einen theoretisch maximalen Phasenstellbereich von 90° ergibt. Gemäß der Erfindung wird dieser Phasenstellbereich durch eine zusätzliche Umkehr des Vorzeichens von $g_{m2}$ innerhalb der Phasenschieberanordnung selbst auf 180° erweitert, was einem Phasenstellbereich von $-g_{m2.max} \leq g_{m2} \leq +g_{m2.max}$ entspricht. Zur Realisierung des erfindungsgemäßen Phasenstellbereich von 360° wird zusätzlich vor oder nach dem modifizierten Phasenschieber eine Anordnung zur Phasenumschaltung angeordnet, welche die Phasenlage des Signals bei Bedarf invertiert.

Somit besteht die Möglichkeit, mittels dieser Erfindung beispielsweise eine auf analogen Schaltungen beruhende Multiplikation eines Signals mit einer komplexen Zahl, welche durch Betrag und Phase charakterisiert ist, zu bewerkstelligen. Dabei liegt der Schwerpunkt bei der Einstellung der Phase.

In einer Ausgestaltung der Erfindung ist vorgesehen, dass der Zirkulator aus einer Reihenschaltung von mehreren Transkonduktanzverstärkern besteht.

In einer Ausführungsform besteht der Zirkulator aus drei in Reihe geschalteten Transkonduktanzverstärkern. Hierbei muss der mittlere Transkonduktanzverstärker eine steuerbare und im Vorzeichen umkehrbare Transkonduktanz $\pm g_{m2}$ aufweisen und mit einer Impedanz $\underline{Z}_x$ an seinem Ausgang abgeschlossen sein. In einer Ausführung der Erfindung ist vorgesehen, dass der Vorzeichenumschalter ein steuerbarer Verstärker mit der Verstärkung $\pm A$ ist.

Das Mittel zur Umschaltung des Vorzeichens oder der Invertierung des Signals kann als ein Verstärker ausgeführt werden. Mittels eines Verstärkers ist neben der Einstellung der Phasenlage auch eine Einstellung der Amplitude des Signals möglich.

In einer Ausführungsform der Erfindung ist vorgesehen, dass der Zirkulator und der Vorzeichenumschalter für eine symmetrische Signalführung ausgeführt sind.

Neben einer unipolaren Signalführung wird erfindungsgemäß auch eine symmetrische Signalführung unterstützt. Diese Art der Signalführung benutzt beispielsweise zwei signalführende Leiter, auf denen gegenphasige, allerdings pegelmäßig identische Signale übertragen werden, und einen Erdleiter, wobei die Summe beider Signale zu jedem Zeitpunkt Null ist. In diesem Anwendungsfall können zumindest teilweise die Transkonduktanzverstärker, wie sie in U. Mayer, F. Ellinger and R. Eickhoff, "Compact Circulator Based Phase Shifter at C-Band in BiCMOS", IEEE Radio Frequency Integrated Circuits Symposium, June 2009 beschrieben wurden, zur Anwendung kommen.

Gemäß der Erfindung wird die Aufgabe verfahrensseitig dadurch gelöst, dass das Signal in einem ersten Phasenstellbereich zwischen 0° und 180° einstellbar ist und eine Einstellung des Signals in einem zweiten Phasenstellbereich zwischen 180° und 360° mittels eines eingangs- oder ausgangsseitigen Mittels zur Phasenumkehr realisiert wird.

Der erste Phasenstellbereich zwischen 0° und 180° realisiert eine Einstellung der Phase eines Signals in diesem Bereich. Dabei ist jeder beliebige Wert innerhalb des Bereiches einstellbar. Liegt die Sollvorgabe für die Einstellung der Phase des Signals im Bereich zwischen 180° und 360°, so wird die Phase des Signals um 180° gedreht oder invertiert und mittel des ersten Phasenstellbereichs sodann im Bereich zwischen 180° und 360° genau eingestellt.

In einer Ausführung der Erfindung ist vorgesehen, dass das Signal ein symmetrisches Signal ist.

Die Erfindung unterstützt auch eine symmetrische Signalführung, wie oben bereits beschrieben.

Die Erfindung soll nachfolgend anhand eines Ausführungsbeispiels näher erläutert werden. In den zugehörigen Zeichnungen zeigt

Fig. 1 eine Darstellung eines unipolaren Phasenschiebers mit einem Verstärker am Eingang,

Fig. 2 eine Darstellung eines unipolaren Phasenschiebers mit einem Verstärker am Ausgang,

Fig. 3 eine Darstellung eines symmetrischen Phasenschiebers mit einem Verstärker am Eingang,

Fig. 4 eine Darstellung eines symmetrischen Phasenschiebers mit einem Verstärker am Ausgang,

Fig. 5 eine Darstellung einer Innenbeschaltung einer gm- Anordnung aus den Figuren 1 bis 4 aus dem Stand der Technik,

Fig. 6 eine erfindungsgemäße Darstellung der Innenbeschaltung einer $g_m$-Anordnung aus den Figuren 1 bis 4 und

Fig. 7 ein normiertes Diagramm der Ströme $I_1$ und $I_2$ aus der Fig. 6.

Der beschriebene Phasenschieber 1 basierend auf einem Zirkulator 4. Dieser wird um die Möglichkeit einer Vorzeichenumkehr des Signals innerhalb des Zirkulators 4 erweitert. Da eine Vorzeichenumkehr durch geeignete Verstärker bzw. im Falle der Verwendung eines symmetrischen Signals leicht realisierbar ist, wird die Komplexität der Schaltung kaum erhöht. Dabei wird der nachfolgend beschriebene Sachverhalt ausgenutzt.

Die Leistungsverstärkung der Schaltung lässt sich unter der Voraussetzung eines idealen Abschlusses am Ein- und Ausgang des Zirkulators wie folgt ausdrükken:

$$\underline{S}_{21} = \frac{1 - g_{m2} * \underline{Z}_x}{1 + g_{m2} * \underline{Z}_x}$$

Wobei $g_{m2}$ die Transkonduktanz (Steilheit) der mittleren Stufe des Zirkulators 4 und $\underline{Z}_x$ die komplexe Impedanz 7 am Ausgang der mittleren Stufe des Zirkulators 4 ist. Die Steuerung der Transkonduktanz $g_{m2}$ im Bereich von $0 \leq g_{m2} \leq g_{m2.max}$ ergibt einen theoretisch maximalen Phasenstellbereich von 90°. Wird jedoch eine zusätzliche Umkehr des Vorzeichens von $g_{m2}$ ermög-

licht, wird der Phasenstellbereich rechnerisch wie auch praktisch auf bis zu 180° verdoppelt und liegt dann im Bereich $-g_{m2.max} \leq g_{m2} \leq g_{m2.max}$.

Eine weitere Verdopplung auf einen Phasenstellbereich von 360° wird durch einen geeigneten vorgelagerten oder nachgeschalteten Verstärker mit Vorzeichenumkehr oder einen Vorzeichenumschalter 5 bei Verwendung symmetrischer Signale bewerkstelligt. Bei Verwendung eines Verstärkers kann dieser ebenso zur Einstellung des Betrags der komplexen Zahl verwendet werden.

Durch diese Möglichkeit einer Vorzeichenumkehr des Signals sowohl außerhalb als auch innerhalb des Zirkulators 4 wird der Phasenstellbereich jeweils verdoppelt und beträgt sodann 360°.

Mit dieser Erfindung ist es beispielsweise möglich, eine komplexe Multiplikation mit dem Phasenschieber 1 basierend auf einer Zirkulator-Anordnung 4 durchzuführen.

Zusammengefasst ergeben sich folgende Vorteile zum Stand der Technik:

- die Schaltung ist kompakt (geringer Flächenbedarf)

- die Schaltung weist eine geringe Dämpfung auf

- Betrag und Phase sind weitestgehend entkoppelt

- die Steuerung der Phase ist stark vereinfacht

- der volle Phasenstellbereich von 360° ist verfügbar

- durch gemeinsam genutzte Komponenten ist ohne weiteren schaltungstechnischen Aufwand gleichzeitig eine Steuerung des Betrags möglich

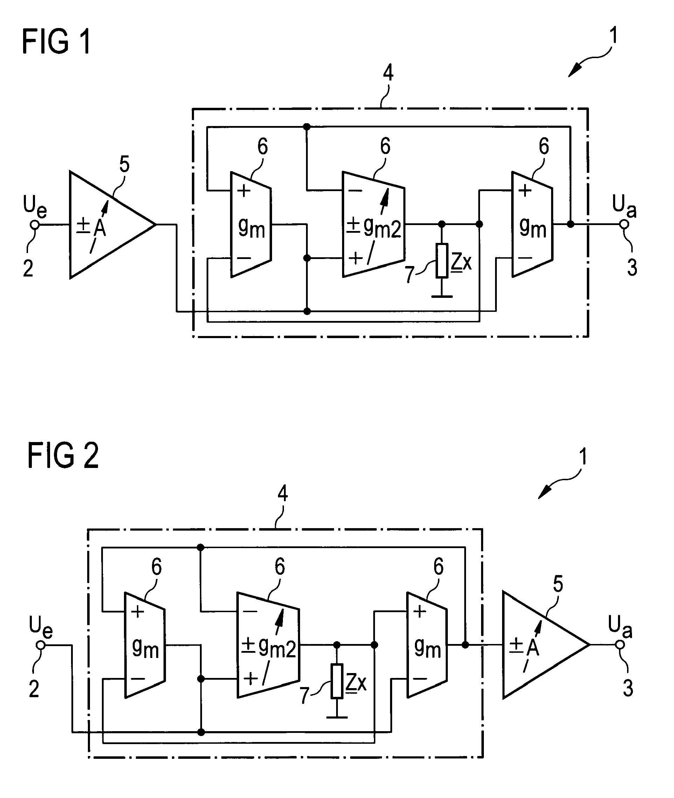

Die Figuren 1 und 2 stellen je einen erfindungsgemäßen Phasenschieber 1 mit unipolarer Signalführung da, wobei der Unterschied in der Lage des Vorzeichenumschalters 5 bzw. steuerbaren Verstärkers besteht. In der Figur 1 wird das Signal, welches am Eingang $U_e$ anliegt, zunächst über den steuerbaren Verstärker ($\pm A$) 5 geleitet, welcher auch als passiver Vorzeichenumschalter 5, wahlweise in Verbindung mit einem Verstärker, ausgeführt werden kann. Dabei ist es wichtig, dass dieser Teil der Schaltung eine Möglichkeit zur Phasenumkehr des Signals bietet. Die Eigenschaft eines steuerbaren Verstärkers wird nur benötigt, falls neben der Einstellung der Phase auch eine Änderung des Betrags des Signals beabsichtigt ist.

Das Signal wird anschließend an den Eingang des Zirkulators 4 geleitet. Im Beispiel ist in den Figuren 1 und 2 eine Kette von Transkonduktanzverstärkern 6 dargestellt. Dabei ist es wichtig, dass der mittlere Transkonduktanzverstärker 6 eine steuerbare und im Vorzeichen umkehrbare Transkonduktanz $\pm g_{m2}$ aufweist und mit einer geeigneten komplexen Impedanz $\underline{Z}_x$ 7 am Ausgang belastet wird. Dafür können entweder ein Kondensator oder eine passive, wie auch aktive Spule verwendet werden. Der Ausgang des Zirkulators 4 ist mit dem Ausgang $U_a$ 3 der Schaltung in der Figur 1 verbunden.

Die Figur 2 unterscheidet sich darin, dass das Signal direkt vom Eingang $U_e$ 2 über den erfindungsgemäßen Zirkulator 4 und anschließend über den geeigneten Vorzeichenumschalter 5 mit oder ohne steuerbarer Verstärkung zum Ausgang der Schaltung $U_a$ 3 geleitet wird. Der Unterschied beider Varianten besteht in der Notwendigkeit, am Ein- und Ausgang des Zirkulators 4 einen möglichst idealen Abschluss zu erreichen. Das bedeutet, dass in der Figur 1 die Ausgangsimpedanz des Verstärkers gleich dem (konjugiert komplexen) Kehrwert der Transkonduktanz $g_m$ der ersten Stufe des Zirkulators sein muss und dass in Figur 2 die Eingangsimpedanz des Verstärkers gleich dem (konjugiert komplexen) Kehrwert der Transkonduktanz $g_m$ der dritten Stufe des Zirkulators sein muss. Der jeweils "offen" liegende Anschluss des Zirkulators muss außerhalb der beschriebenen Schaltung geeignet angepasst werden.

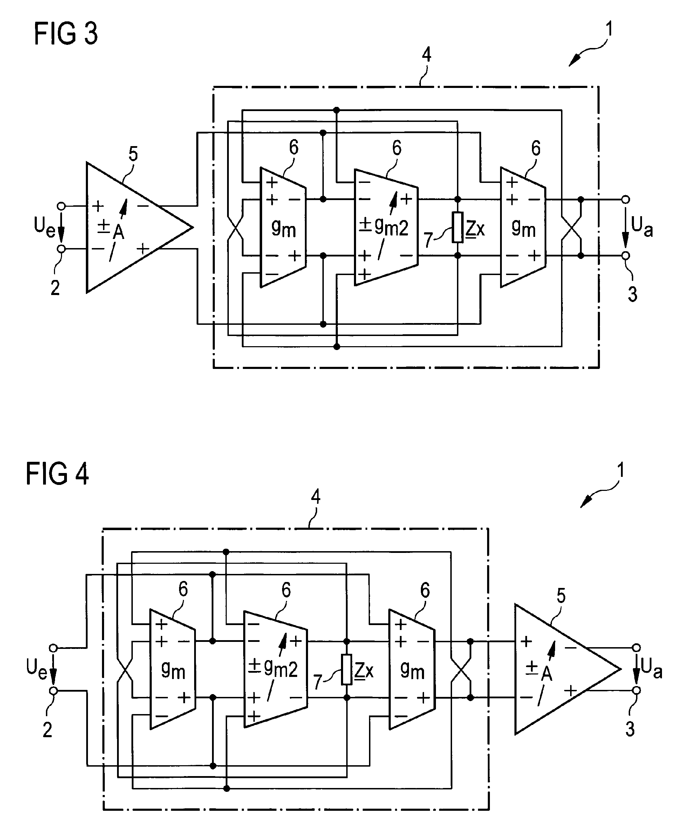

Die Figur 3 und 4 stellen den gleichen Sachverhalt analog zu den Figuren 1 und 2 jedoch mit einer symmetrischen Signalführung dar. Alle genannten Bedingungen und Eigenschaften gelten auch für diese Schaltungen. Dazu kommt, dass aufgrund der symmetrischen Signalführung spezielle Transkonduktanzverstärker, wie sie bereits in U. Mayer, F. Ellinger and R. Eickhoff, "Compact Circulator Based Phase Shifter at C-Band in BiCMOS", IEEE Radio Frequency Integrated Circuits Symposium, June 2009 beschrieben wurden, bevorzugt verwendet werden.

Generell können für die jeweiligen Spannungs- und Transkonduktanzverstärker 6 beliebige Schaltungsvarianten verwendet werden, sofern sie den Eigenschaften eines Spannungs- bzw. Transkonduktanzverstärkers 6 bei der jeweils gewünschten Signalfrequenz genügen.

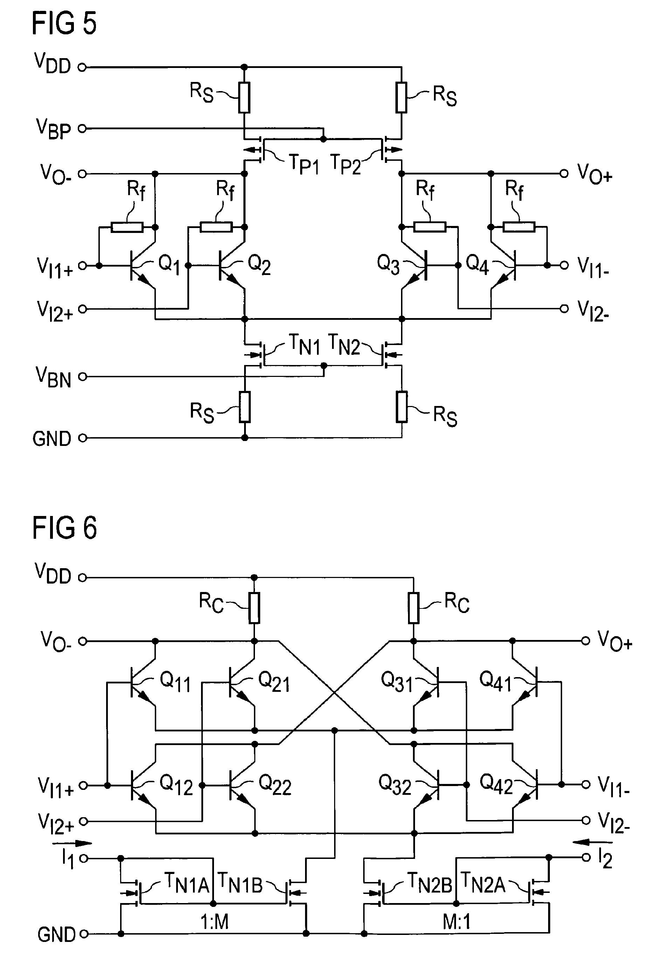

Die Figur 5 zeigt eine aus dem Stand der Technik bekannte Differenzverstärker-Anordnung mit zwei symmetrischen Eingängen und einem symmetrischen Ausgang, wie sie in einem der in den Figuren 3 oder 4 dargestellten Transkonduktanzverstärkern 6 eingesetzt werden kann.

Die Differenzpaare werden jeweils durch die Transistoren $Q_1$ und $Q_4$ sowie $Q_2$ und $Q_3$ gebildet. Alle Transistoren sind jeweils am Emitter mit einer gemeinsamen Stromquelle $T_{N1}$ und $T_{N2}$ verbunden. Die Transistoren mit gleichem Eingangsverhalten, also nicht invertierend $Q_1$, $Q_2$ und invertierend $Q_3$, $Q_4$, sind jeweils am Kollektor miteinander, mit einem gemeinsamen Ausgangsknoten $V_o$-, $V_o$+ sowie mit den aktiven Lasten $T_{P1}$ und $T_{P2}$ verbunden.

Die hochohmigen Widerstände $R_f$ dienen der Arbeitspunkteinstellung der Eingangstransistoren und können auch für Gegenkopplung verwendet werden. Der Ruhestrom und damit die Transkonduktanz $g_m$ wird über die Stromquellen $T_{N1}$ und $T_{N2}$ mittels der Steuerspannung $V_{BN}$ eingestellt. Somit ergibt sich die Notwendigkeit, dass die Steuerspannung $V_{BP}$ für die aktiven Lasten

$T_{P1}$ und $T_{P2}$ entsprechend nachgeführt oder besser geregelt werden muss. Die niederohmigen Widerstände $R_S$ dienen der Stromgegenkopplung für $T_{N1}$, $T_{N2}$ und $T_{P1}$, $T_{P2}$ um den Ausgangswiderstand der Stromquellen und aktiven Lasten zu verbessern.

Die Nachteile dieser Anordnung liegen in einer aufwendigen Nachführung der aktiven Lasten ($V_{BP}$) bei Veränderung des Ruhestroms (VBN) sowie schlechten HF-Eigenschaften der aktiven Lasten.

Die Figur 6 zeigt eine erfindungsgemäße Differenzverstärker-Anordnung mit zwei symmetrischen Eingängen und einem symmetrischen Ausgang, wie sie in einem der in den Figuren 3 oder 4 dargestellten Transkonduktanzverstärkern 6 eingesetzt werden kann.

Die Differenzpaare werden jeweils durch Transistoren $Q_{11}$, $Q_{12}$ und $Q_{41}$, $Q_{42}$ sowie $Q_{21}$, $Q_{22}$ und $Q_{31}$, $Q_{32}$ gebildet. Alle Transistoren $Q_{x1}$, welche zugehörig zur Steuergröße $I_1$ sind, werden jeweils am Emitter mit einer gemeinsamen Stromquelle $T_{N1B}$ verbunden. Alle Transistoren $Q_{x2}$, welche zugehörig zur Steuergröße $I_2$ sind, werden jeweils am Emitter mit einer gemeinsamen Stromquelle $T_{N2B}$ verbunden.

Die Transistoren mit gleichem Eingangsverhalten, welche zugehörig zur Steuergröße $I_1$ sind, also nicht invertierend $Q_{11}$, $Q_{21}$ und invertierend $Q_{31}$, $Q_{41}$, werden jeweils am Kollektor miteinander, mit einem gemeinsamen Ausgangsknoten $V_o$-, $V_{o+}$ und mit den passiven Lasten $R_C$ verbunden.

Die Transistoren mit gleichem Eingangsverhalten, welche zugehörig zur Steuergröße $I_2$ sind, also nicht invertierend $Q_{12}$, $Q_{22}$ und invertierend $Q_{32}$, $Q_{42}$, werden jeweils am Kollektor miteinander, mit einem gemeinsamen in Bezug auf die andere Steuergröße kreuzgekoppelten Ausgangsknoten $V_{o+}$, $V_{o+}$ und mit den passiven Lasten $R_C$ verbunden.

Der Ruhestrom und damit die Transkonduktanz $g_m$ wird über die Stromspiegel $T_{N1A}$-$T_{N1B}$ und $T_{N2A}$-$T_{N2B}$ mittels der Steuerströme $I_1$ und $I_2$ eingestellt. Eine Über- oder Untersetzung der Steuerströme in einem Verhältnis M:1 oder 1:M ist dabei zusätzlich einstellbar.

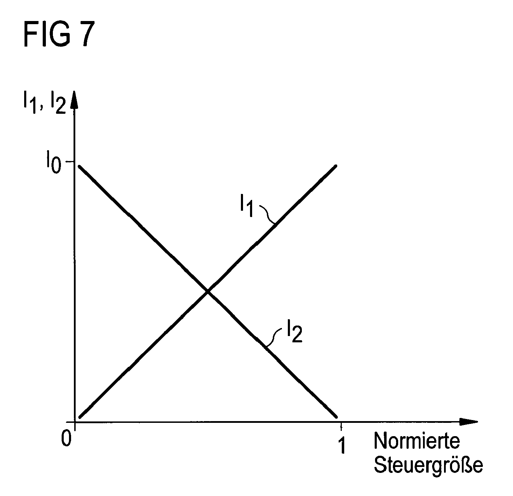

Die beiden Steuerströme $I_1$ und $I_2$ müssen in ihrer Summe stets einen konstanten Wert $I_0$ aufweisen. D.h. dass sich in dem Maß wie sich $I_1$ ändert, auch $I_2$ mit umgekehrtem Verlauf ändern muss, wie es in der Figur 7 für beide Ströme in einem Diagramm dargestellt ist.

Da der Summenstrom von $I_1$ und $I_2$ stets konstant ist, wird im Arbeitspunkt, durch die Kreuzkopplung der Ausgänge der den Steuerströmen zugehörigen Transistoren, ein konstanter Strom M * $I_0$ durch die Widerstände $R_C$ fließen. Damit sind die Arbeitspunkte der Ausgangsspannungen für alle eingestellten Transkonduktanzen $g_m$ ohne aufwendige Regelung gleich. Hierin ist ein besonderer Vorteil dieser erfindungsgemäßen Ausgestaltung zu sehen. Dadurch wird weiterhin eine Verkopplung aus Amplitude und Phase weitestgehend verhindert.

## Bezugszeichenliste

1 Phasenschieber

2 Eingang $U_e$

3 Ausgang $U_a$

4 Zirkulator

5 Vorzeichenumschalter

6 Transkonduktanzverstärker

7 Impedanz

## Patentansprüche

1. Anordnung zur Einstellung einer Phase eines Signals, bei welcher zwischen einem Eingang $U_e$ (2) und einem Ausgang $U_a$ (3) ein Zirkulator (4) angeordnet ist, **dadurch gekennzeichnet, dass** der Zirkulator (4) eine in einem Phasenstellbereich zwischen $-g_{m2.max} \leq g_{m2} \leq g_{m2.max}$ einstellbare Transkonduktanz $g_{m2}$ aufweist, und dass zwischen dem Eingang $U_e$ (2) und dem Zirkulator (4) oder zwischen dem Zirkulator (4) und dem Ausgang $U_a$ (3) ein Vorzeichenumschalter (5) angeordnet ist.

2. Anordnung nach Anspruch 1, **dadurch gekennzeichnet, dass** der Zirkulator (4) aus einer Reihenschaltung von mehreren Transkonduktanzverstärkern (6) besteht.

3. Anordnung nach Anspruch 1, **dadurch gekennzeichnet, dass** der Vorzeichenumschalter (5) ein steuerbarer Verstärker mit der Verstärkung $\pm A$ ist.

4. Anordnung nach Anspruch 1 bis 3, **dadurch gekennzeichnet, dass** der Zirkulator (4) und der Vorzeichenumschalter (5) für eine symmetrische Signalführung ausgeführt sind.

5. Verfahren zur Einstellung einer Phase eines Signals, bei welchem die Phase mittels eines Zirkulators (4) einstellbar ist, **dadurch gekennzeichnet, dass** das Signal in einem ersten Phasenstellbereich zwischen 0° und 180° einstellbar ist und eine Einstellung des Signals in einem zweiten Phasenstellbereich zwischen 180° und 360° mittels eines eingangs- oder ausgangsseitigen Mittels zur Phasenumkehr (5) realisiert wird.

6. Verfahren nach Anspruch 5, **dadurch gekennzeichnet, dass** das Signal ein symmetrisches Signal ist.

## FIG 1

## FIG 2

FIG 3

FIG 4

FIG 5

FIG 6

# FIG 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **F. Ellinger ; H. Jäckel ; W. Bächtold.** Varactor-loaded transmission-line phase shifter at C-band using lumped elements. *IEEE Trans. Microwave Theory & Tech.,* April 2003, vol. 51, 1135-1140
- **C. Lu ; A.H. Pham ; D. Livezey.** On the feasibility of CMOS multiband phase shifters for multiple-antenna transmitters. *IEEE Microwave and Wireless components letters,* Mai 2006, vol. 16, 255-257
- **J. Wagner ; U. Mayer ; F. Ellinger.** Passive transmission line phase shifter at C-band in CMOS using lumped elements. *IEEE International Conference on Microwaves, Radar and Wireless Communication,* Mai 2008, 1-4
- **S. Lucyszyn ; I. D. Robertson.** Decade bandwidth MMIC analogue phase shifter. *IEE Colloquium on Multi-Octave Microwave Circuits,* November 1991, 2, 1-26
- **H. Hayashi ; M. Muraguchi.** An MMIC active phase shifter using a variable resonant circuit. *IEEE MTT-S International Microwave Symposium Digest,* Juni 1998, vol. 3, 1573-1576
- **Y. Zheng ; C. E. Saavedra.** An ultra-compact CMOS variable phase shifter for 2.4-GHz ISM applications. *IEEE Trans. Microwave Theory & Tech.,* Juni 2008, vol. 56 (6), 1349-1354
- **U. Mayer ; F. Ellinger ; R. Eickhoff.** Compact Circulator Based Phase Shifter at C-Band in BiCMOS. *IEEE Radio Frequency Integrated Circuits Symposium,* Juni 2009